# EUROPEAN PATENT APPLICATION

(11) **EP 4 746 037 A1**
(43) Date of publication of application: **20.05.2026**
(21) Application number: 24213416.1
(22) Date of filing: 15.11.2024
(51) Int. Cl.: H01L 23/00, H01L 25/07, H01L 23/498

(54) **CLIP FOR DIE TOP INTERCONNECTION OF POWER MODULE APPLICATIONS**

(71) Applicant: Zhuzhou CRRC Times Semiconductor Co. Ltd, Shifeng District Zhuzhou Hunan 412001 (CN); Dynex Semiconductor Limited, Lincoln, Lincolnshire LN6 3LF (GB)
(72) Inventor: Morshed, Muhammad, Lincoln, LN6 7HL (GB); Mat, Maryam Khalilah Binti, Lincoln, LN6 3NL (GB); Xiang, Li, Lincoln, LN6 8QY (GB)
(74) Representative: Marks & Clerk LLP

(57) **Abstract**

An interconnection clip for a semiconductor package and semiconductor device or package comprising the same. The clip comprises a first metal and a second metal, wherein the first metal is copper and the second metal is tungsten or molybdenum; and one or more cavities provided on a first side of the clip, wherein the first side of the clip is configured for attachment to a die top of the semiconductor package.

## Description

### Field of Disclosure

The present application relates to a clip for use with a semiconductor die, and in particular but not exclusively to a clip for die interconnections in power module applications.

### Background

Power electronics play an increasingly important role in the development of high current density power modules, generally facilitating more compact, lightweight, energy efficient and cost-effective designs. To achieve these advantages, the packaging of a semiconductor die is highly important. This is because it facilitates both the provision of electric connections for the chip, and any necessary power dissipation.

Packaging technologies typically act as the main limiting factor for the performance of power semiconductor devices. Wire bonding is the oldest and the most widespread technology used in the industry for die interconnections. Wire bonding provides a straightforward, flexible, and cost-effective solution for die packages. However, wire bonds are often the weakest part of power module device, providing a common failure point. The most established wire materials are aluminium (Al), copper (Cu), and gold (Au) because of their high electrical and thermal conductivity. Because of the rising speculative price of Au, attempts have been made to replace Au with Cu, despite the generally superior performance of Au wire bonds. Cu wires face more challenges in the packaging process because of their strain hardening, higher hardness and modulus properties. For example, thick Cu metallization of die bond pad may be required for reliable Cu wire bonding. Alternately, a Cu buffer layer on top of the die can be provided for a Cu wire bond connection, however this requires an additional process step to sinter the buffer layer. In addition, the oxidation issue of Cu metallisation may cause difficulties in Cu wire bonding processes.

Clip interconnections may be an alternative to wire bonding, by providing a "bond-less" packaging technology. Clip interconnections can replace wire bonds in the packaging for many semiconductor packages, such as those with double-sided cooling and 3D integration systems. This technique consists of connecting the active area of a die to the package lead frame using a small metal slab, which in turn is directly soldered on the die's top surface. A common clip material is copper.

Clip interconnections may provide lower resistance and lower inductances, particularly when replacing multiple wire bonds. A variety of Cu-based interconnections can be provided based on the needs of the semiconductor package, such as Cu clips, Cu ribbons, Cu pins, thin film Cu as well as thick Cu layers. Generally speaking, each of these options may improve thermal performance over wire bonds by allowing a larger contact area and current distribution into the device. As a result, maximum junction temperatures during the power device operation can be more easily maintained, which extends the device operational lifetime and reliability.

Despite being more durable than wire-bonds, a common failure condition of copper clips (and other copper interconnections) is the clip becoming detached from the die top. This may be caused by differences in the thermal expansion coefficient (CTE) between the copper clip (approx. 16.5 µm/m·K) and the die (e.g. 2.6-3.3µm/(m·K) for silicon and 4.0µm/(m·K) for silicon carbide). Such mismatches may result in thermomechanical stress on either the soldering/sintering layer or the chip metallisation layer when the junction temperature changes during the power cycling process.

The Applicant has therefore recognised a need for an improved die interconnection means, in particular but not exclusively for power module applications.

### Summary

Aspects and preferred features are outlined in the accompanying claims.

The present disclosure provides a clip that facilitates an enhanced thermal and electrical connection for a semiconductor top die interconnection relative to a conventional wire bond or copper clip interconnection. Clip design structures according to the present disclosure may improve the lifetime performance of a semiconductor package. Such clips may be formed from materials and/or material structures with a relatively low CTE mismatch to typical semiconductor die materials, to further enhance lifetime performances relative to traditional copper clips.

According to a first aspect of the present disclosure, there is provided a clip for a semiconductor package, the clip comprising:
a first metal and a second metal, wherein the first metal is copper and the second metal is tungsten or molybdenum; and
one or more cavities provided on a first side of the clip, wherein the first side of the clip is configured for attachment to a die top of the semiconductor package.

The material composition and/or structure of the clip may be selected to provide a closer CTE match to typical semiconductor die materials. For example, the second metal may be tungsten. The clip may comprise an alloy that comprises 75 to 90% tungsten by weight. For example, the alloy may comprise 90% tungsten and 10% copper, 80% tungsten and 20% copper, 75% tungsten and 25% copper, or any other tungsten:copper ratio suitable for an intended use or application.

Alternatively, where the second metal is molybdenum, the alloy may comprise 65 to 85% molybdenum by weight. For example, the alloy may comprise 85% molybdenum and 15% copper, 70% molybdenum and 30% copper, 65% molybdenum and 35% copper, or any other molybdenum:copper ratio suitable for an intended use or application.

In another implementation, the clip may comprise a laminate or sandwich structure, with material layers selected and formed to provide closer CTE matching. For example, the clip may comprise:
a first layer and a second layer comprising the first metal; and
a third layer positioned between and separating the first and second layers, wherein the third layer comprises the second metal.

In a laminate structure clip, the one or more of the cavities may form blind-holes. For example, the one or more cavities may extend from the first side of the clip and only through the first layer, i.e. such that they do not extend through the second or third layers.

Optionally, the clip may comprise one or more second cavities provided on a second side of the clip and extending only through the third layer, i.e. such that they do not extend through the second or first layers. The second side of the clip may be opposite the first side of the clip.

Each of the second cavities may correspond to a first cavity such that the first and second cavities are aligned with one another on opposing sides of the clip. In other words, the first and second cavities together may form an opening in the clip that extends through the first and second layers, but does not extend through the third (i.e. middle) layer.

In implementations, the second metal in the laminate structure is molybdenum.

The first, third and second layers may have a thickness ratio of 13:74:13, 20:60:20 or any other suitable ratio.

In implementations, the one or more cavities may extend from the first side of the clip to a second, opposite side of the clip to thereby form a through-hole.

In some implementations, some of the one or more cavities may form blind holes (alone or in combination with one or more second cavities), while others of the one or more cavities may form through-holes.

In implementations, a total thickness of the clip is at least 100µm. A clip thickness of at least 100µm may provide a reasonable current carrying capacity level across its entire expected operational lifetime. In implementations, a total thickness of the clip may be between 200µm and 500µm.

According to a second aspect of the present disclosure, there is provided a semiconductor device or package comprising a clip according to the first aspect.

The clip may be attached to a die top of the semiconductor device or package by soldering or sintering, for enhanced further device longevity and reliability.

The semiconductor device or package may comprise direct liquid cooling (DLC) or double sided cooling (DSC) power module packaging technology, and/or may utilise discrete packaging with a single die, Quad Flat No lead (QFN) packaging.

Clips according to the present disclosure may be suitable for use with any semiconductor device or package, including but not limited to Si (MOSFET, IGBT) and WBG (SiC and GaN HEMT) modules.

### Brief Description of the Figures

Some preferred embodiments of the invention will now be described, by way of example only and with reference to the accompanying drawings, in which:
Figures 1a and b illustrate example clips for die interconnections.
Figures 2a and b illustrate further example clips for die interconnections.
Figure 3 illustrates another example clip for die interconnections.
Figures 4a and b illustrate an example semiconductor die package comprising an example clip for die interconnections.
Figures 5a and b depict performance characteristics of example semiconductor die packages.
Figures 6a and b depict operational cycle characteristics of example semiconductor die packages.
Figure 7 illustrates comparison images of pre- and post-cycling example semiconductor packages.
Figure 8 depicts a table showing characteristics of various example material combinations for clips for die interconnections.

### Detailed Description of the Preferred Embodiments

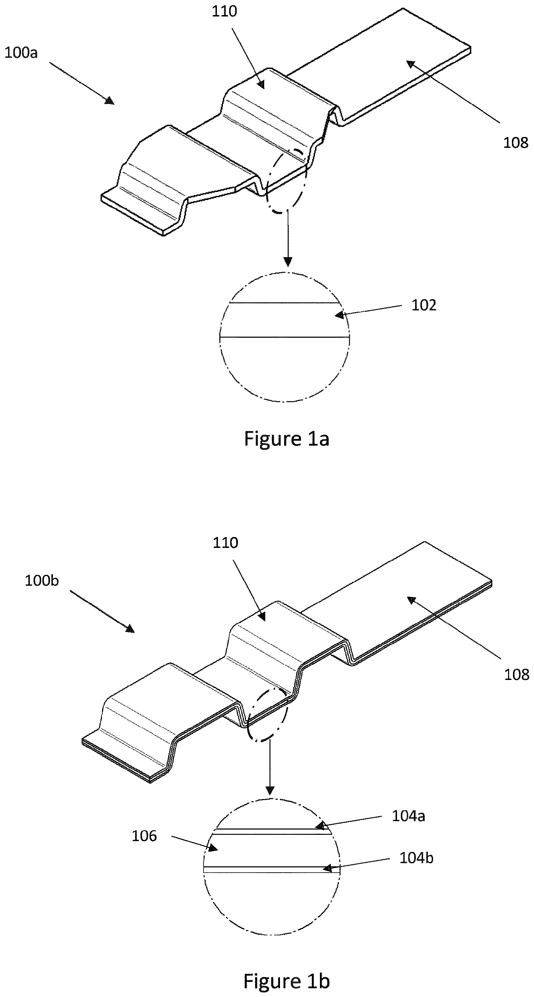

Figure 1a depicts an example clip 100a for semiconductor die top interconnections. The clip comprises one or more die connection portions 108 for connection to a semiconductor die package, and one or more connection portions 110 between die connection portions 108. The die connection portions 108 may be electrically connected to a semiconductor die package via any suitable means, for example via solder, sintering, or any other electrically conductive attachment layer or material.

Clip 100a comprises a first material 102. Figure 1b depicts a second example clip 100b that corresponds to clip 100a. However, clip 100b comprises a sandwich or laminate structure formed of first (e.g. top) and second (e.g. bottom) layers 104a, b comprising a second material, and a third (e.g. middle) layer 106 comprising a third material between the first and second layers 104a, b. The first, second and third layers may be joined via any suitable means, for example by welding, sintering, soldering, or the use of any other electrically conductive joining material.

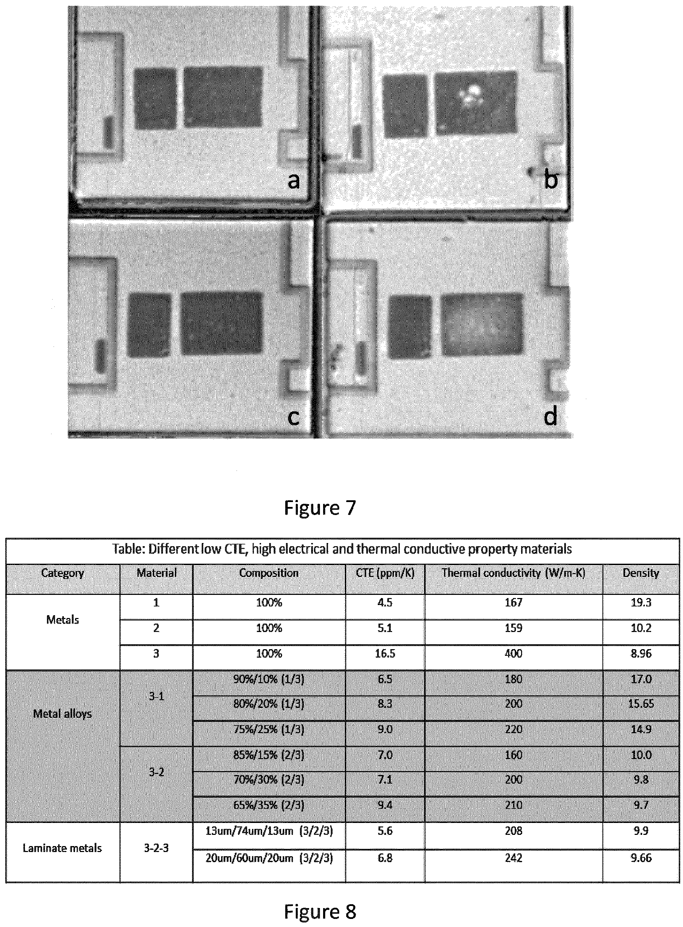

The first material may be e.g. a metal or a metal alloy. Characteristics of various suitable example materials are shown in the table of Figure 8, including metals such as Tungsten (material 1), Molybdenum (material 2) and Copper (material 3), and metal alloys such as Copper-Tungsten (material 3-1) and Copper-Molybdenum (material 3-2). Similarly, each of the second and third materials may also be e.g. a metal or metal alloy, and may comprise the same or different materials to the first material. For example, Figure 8 shows characteristics of an example laminate metal structure, comprising a Copper-Molybdenum-Copper (material 3-2-3) sandwich structure.

Materials alloys and laminate structures such as those shown in Figure 8 provide a coefficient of thermal expansion (CTE) that more closely matches semiconductor device materials compared to pure copper, along with a high electrical conductivity and high thermal conductivity. Such materials and/or structures may therefore facilitate the design of an interconnection clip e.g. for top die interconnections, with improved power cycling reliability and longevity (i.e. operational life times). The material selection may be based on various considerations, including cost, clip manufacturability, and the physical, electrical, thermal and other mechanical properties of the material. To achieve suitable performance of power cycling reliability, different percentages of binary alloy composition (e.g. 90/10, 80/20, 75/25 and 85/15, 70/30, 65/35 etc.) and/or different thicknesses or thickness ratios of laminated sandwich metal sheets (e.g., 13:74:13, 20:60:20 etc.) may be provided. The materials may be passed through any suitable manufacturing processes, for example annealing or tempering processes for improving their mechanical strength, malleability and manufacturability.

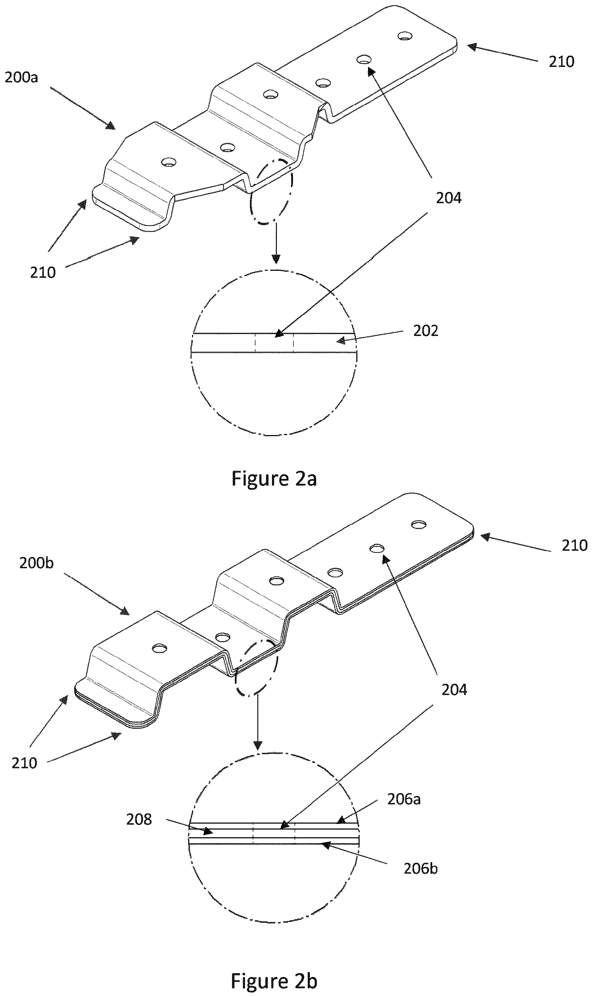

Figures 2a and 2b show second example clips 200a and 200b. Clip 200a generally corresponds to clip 100a, and comprises first material 202. Clip 200b generally corresponds to clip 100b, and comprises a sandwich structure formed from first (e.g. top) and second (e.g. bottom) layers 206a, b comprising a second material, and a third (e.g. middle) layer 208 comprising a third material between the first and second layers 206a, b.

Each of clips 200a, b comprises one or more through holes, cavities or openings 204. The use of circular cavities may improve the homogeneity of the mechanical stress distribution along the clip and thereby enhance mechanical reliability. However, it will be understood that any shape may be provided for the through holes 204, inducing ovals, slots, triangles, squares, etc. or irregular shapes. Each through hole 204 comprises a cavity extending through the clip 200a,b from a first (e.g. bottom) surface to an opposing second (e.g. top) surface. Through holes 204 may be provided on one or both of the die connection portions and the connection portions. The number, shape and spacing of through holes 204 may be selected so as to account for differences between the CTE (and other properties) of the clip and the semiconductor die and/or semiconductor die package.

Additionally, any through holes 204 provided on a die connection portion of the clips 200a,b may further enhance a connection strength between the clip and the die top. For example, excess sinter or solder material may flow through and out of a through holes 204, forming a plug by partially or fully filling the through hole 204, to thereby increase a mechanical strength of the joining. In some implementations, excess joining material may flow out of a top end of the through hole 204, forming a rivet joint extending though the clip structure. In a laminate structure clip, the rivet joint or plug may further enhance an interconnection of the top, bottom and middle layers of the structure, thereby further increasing the current carrying capability.

Thus, through holes 204 may enhance the mechanical reliability of the clip and/or its connection to a semiconductor die as well as its current carrying capacity, and therefore also improve the operational lifetime of the semiconductor package.

Optionally, clips 200a,b may be provided with rounded corners or edges 210. The use of rounded corners 210 may assist in improving the distribution of mechanical stresses, in addition to increasing the homogeneity of the electric field distribution at the surface of the clips. This improved homogeneity may in turn reduce the risk of arcing or other undesirable electrical discharges during use. It will be understood that each implementation of the present disclosure may be provided with rounded edges such as edges 210 or square edges such as those depicted in Figures 1a,b.

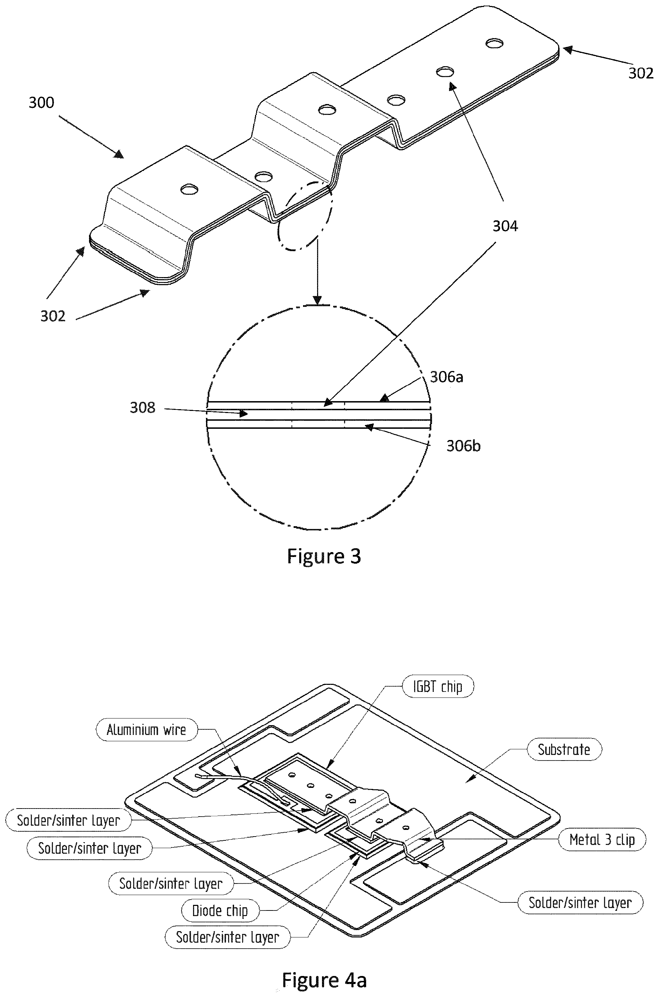

Figure 3 depicts a further example clip 300. Clip 300 generally corresponds to clip 100b, and comprises a sandwich structure formed from first (e.g. top) and second (e.g. bottom) layers 306a, b comprising a second material, and a third (e.g. middle) layer 308 comprising a third material between the first and second layers 306a, b. Optionally, clip 300 may be provided with rounded corners 302 (as shown), or may otherwise comprise square corners such as those depicted in Figures 1a,b.

Clip 300 comprises one or more cavities or openings forming blind holes 304. The use of circular cavities may improve the homogeneity of the mechanical stress distribution along the clip and thereby enhance mechanical reliability. However, it will be understood that any shape may be provided for the blind hole 304, inducing ovals, slots, triangles, squares, etc. or irregular shapes. Each of the blind holes 304 comprises a cavity in the first (e.g. top) layer 306a and a corresponding (i.e. vertically aligned) cavity in the second (e.g. bottom) layer 306b. However, in contrast to a through hole, blind holes 304 do not extend through the third (e.g. middle) layer 308. Advantageously, blind holes 304 may therefore be designed to account to for differing CTE (and other properties) between the second and third materials, for example to facilitate different degrees of expansion between the two materials at operational temperatures. Blind holes 304 may therefore further enhance the mechanical reliability of the clip 300 and the operational lifetime of the clip, as well as improving the joining between the clip and the die top.

It will be understood that one or more of the cavities forming blind holes may be misaligned with their corresponding cavities in the opposing layer, and/or may not have a corresponding cavity in the opposing layer. For example, in a clip with top and bottom layers of different thicknesses, additional blind holes and/or blind holes in different locations may be provided for one of the layers.

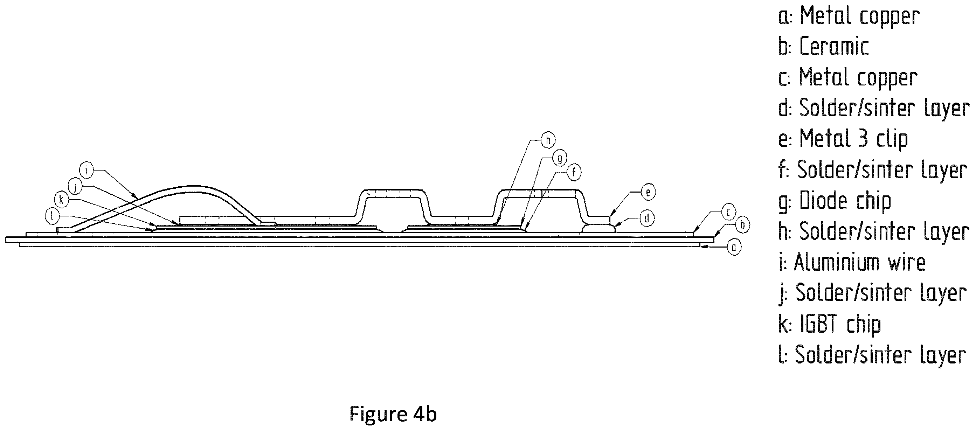

Figures 4a and 4b show views of an example semiconductor die package comprising an interconnection clip according to the present disclosure. It will be understood that the clip may be any clip as previously described. The interconnection clip may be joined (e.g. via sinter or solder) to a top surface of one or more dies in a semiconductor package. The semiconductor dies may in turn be connected to a substrate, for example by a soldering or sintering with single or double reflow process. An aluminium wire may be provided to connect the substrate gate area to a semiconductor die, for providing power cycling control.

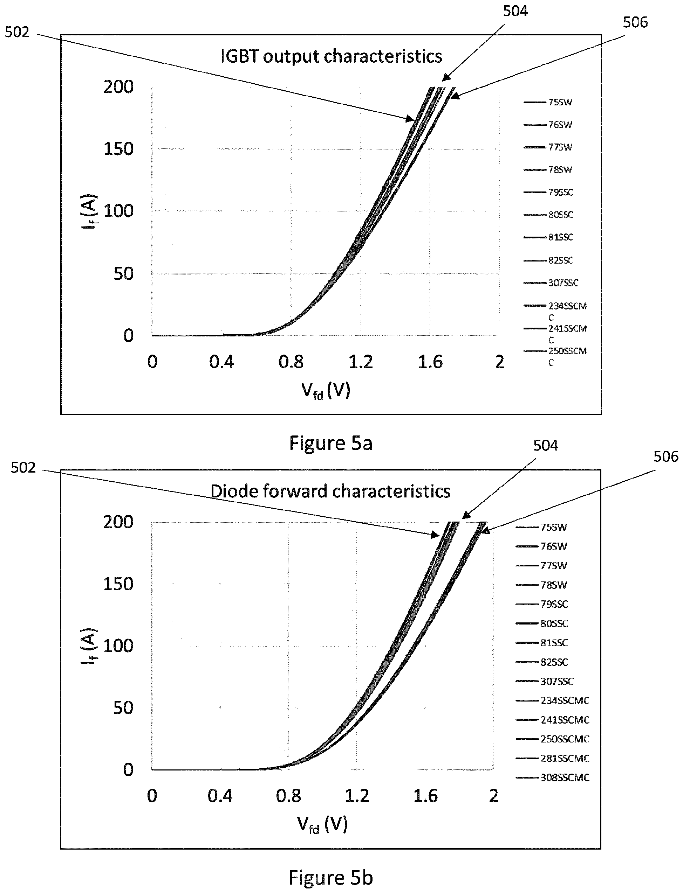

Figure 5a shows a current-voltage graph for IGBT output for an example IGBT semiconductor die package. Outputs of three example die packages are depicted in Figure 5a: output 502 corresponding to an example semiconductor package comprising a copper interconnection clip, output 504 corresponding to an example semiconductor package comprising a laminate structure interconnection clip comprising a copper-molybdenum-copper structure, and output 506 corresponding to an example semiconductor package comprising a wire bond interconnection. As depicted in Figure 5a, semiconductor packages comprising interconnection clips according to the present disclosure provide an enhanced current output for operational voltage levels relative to traditional wire bonds.

Figure 5b shows a current-voltage graph for a diode in a forward direction in an example semiconductor die package. Outputs of three example die packages are again depicted in Figure 5b: output 502 corresponding to an example semiconductor package comprising a copper interconnection clip, output 504 corresponding to an example semiconductor package comprising a laminate structure interconnection clip comprising a copper-molybdenum-copper structure, and output 506 corresponding to an example semiconductor package comprising a wire bond interconnection. As depicted in Figure 5b, interconnection clips according to the present disclosure provide an enhanced current output for operational voltage levels relative to traditional wire bonds.

In both tests, conventional wire bond test vehicle samples 506 provide a baseline comparison for the clip interconnection semiconductor packages 502, 504. The electrical resistance of die top interconnection depends on the resistivity, length and cross-section area of the interconnection materials. An increased voltage causes the semiconductor package to be less efficient. In addition, a lower voltage reduces the material strain energy in the interconnection material and decreases the conduction losses, further enhancing the reliability of the package.

The difference in electrical performance between the example clip type interconnections and the conventional wire bonding results in the example clip interconnection devices having a Vce(on) of 1.6212 V at 200 A for a 1200V IGBT, and the wirebond sample a Vce(on) of 1.756 V at the same current. The Vce(on) for the aluminium wire bond device is higher because of its lower electrical conductivity, and because it comprises a smaller connection area to the top of the die surface. This is a voltage increase of 8.3% in the convention wire bond approach relative to the clip interconnect, thereby causing the Al wire bond package to be less efficient, and increasing strain on the Al material to thereby reduce the reliability of the semiconductor die package.

The ability of the clip materials to withstand the thermally induced stress assists in reducing plastic deformation during thermal cycling, providing higher mechanical strength, higher melting temperature, and minimising the creepage effect. The use of a Cu clip not only reduces the emitter contact resistance but also provides the additional heat dissipation path from the top side of the die, it also reduces both the inner resistance and inductance to about 50% relative to a wire bond example. However, use of a Cu clip generally results in a CTE mismatch with the semiconductor materials. In example package 504, clip materials and structures are provided with a CTE that is a closer match to typical semiconductor materials (e.g., Si, SiC), to thereby facilitate an improved power cycling lifetime. In terms of thermal performance, the thermal resistance is reduced significantly due to the additional thermal path provides by clip interconnection to substrate and die surfaces. Clips according to the present disclosure may therefore provide high temperature capabilities, high humidity resistance and high mechanical stability in power modules.

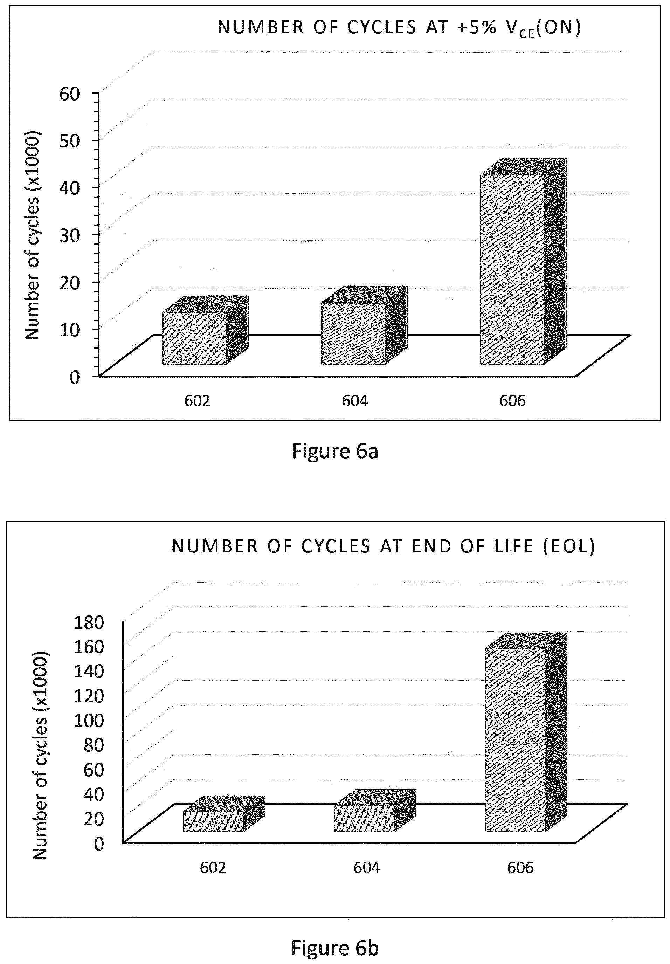

Figures 6a and 6b show further power cycling test results for an example semiconductor package comprising an Al wire bond interconnection 602, an example semiconductor package comprising a copper clip 604, and an example semiconductor package comprising a laminate structure interconnection clip 606 comprising a copper-molybdenum-copper structure. As clearly shown in Figures 6a, 6b, the enhanced CTE matching of the laminate structure clip in example package 606 provides a clear lifetime improvement over the highly mismatched CTE Cu clip and aluminium wire bond examples 602, 604. The power cycling conditions used for this test are delta T=120K, maximum junction temperature Tjmax=150°C, minimum junction temperature Tjmin=30°C, current switching through the device Ic=145A variable and ton/toff =0.5s/3.1s (total cycle time 3.6s). The two criteria for determining the longevity of the test samples are the number of cycles for a +5% increase of Vce(on), and the degradation of the die interconnected layer detected due to an increased thermal resistance (Rth) of more than 20%. The total cycle number before the "end of life" is defined by the IGBT chip failure or the electrical connection otherwise becoming non-functional.

In Figure 6a, the low CTE mismatch clip interconnection materials 606 facilitate an increase in the number of cycles of approx. 3.64 times over the baseline Al wire bond 602, while the higher CTE mismatch clip interconnection material 604 provides only an approx. 1.18 increase over the same baseline. In Figure 6b, the increase in the number of cycles for example package 606 is approx. 9.25 times and approx. 7 times relative to the baseline (Al wire bond) and Cu clip semiconductor packages 602, 604 respectively.

As such, the low CTE mismatch clip sample semiconductor package 606 achieves a more gradual increase in Vce(on), which is indicative of any degradation process proceeding at a slower rate. The higher CTE mismatch clip and baseline wire bond sample semiconductor packages 602, 604 fail at a much smaller number of cycles. This may be caused by the clip and/or wire bond becoming detached and thereby causing localised heating in a section of the die top, thus damaging the die.

Figure 7 shows SAM (scanning acoustic microscopy) images of semiconductor die tops following an 'end of life' power cycling test. Images a and b show die tops of an example semiconductor package pre- and post-cycling with a Cu clip interconnection, while images c and d show corresponding die tops of an example semiconductor package pre- and post-cycling with a laminate structure interconnection clip comprising a copper-molybdenum-copper structure. As visible in these images, the low CTE mismatch, laminate structure clip (image d) facilitates consistent voiding over the whole die solder area, with only relatively small areas being completely devoid of the solder joint material. The high CTE mismatch Cu clip (image b) by contrast has more significant voiding with larger areas being completely devoid of die solder, which may result in localised hot-spots during the power cycling test. This may result in an increased likelihood of failure at lower cycle numbers. The increased voiding may be caused by the higher thermal expansion causing more strain in certain locations on the Cu clip. On the other hand, the laminate structure clip provides a smaller difference in expansion when compared to the die, resulting in less strain and a more uniform degradation across the entirety of the die area.

Figure 8 provides a table listing characteristics of various materials for interconnection clip design, including metals such as Tungsten (material 1), Molybdenum (material 2) and Copper (material 3), and metal alloys such as Copper-Tungsten (material 3-1) and Copper-Molybdenum (material 3-2) with various alloy ratios. Figure 8 further shows characteristics of an example laminate metal structure, comprising a Copper-Molybdenum-Copper sandwich structure (material 3-2-3). It will be understood that, while the composition of the laminate structure clip is provided in terms of a specific example thickness of each of the three layers of the structure, identical properties can be obtained by maintaining a same thickness ratio for each of the three layers. As such, a total thickness of the interconnection clip may be adjusted to suit the needs and requirements of the intended use case. Additionally, it will be understood that the alloy and laminate structure compositions listed in Figure 8 are merely examples, and are not intended to be limiting in nature.

Cu-W alloys (material 3-1) are easily machinable, and provide a high arc resistance, good electrical conductivity and good thermal conductivity. Cu-W has an adjustable CTE and thermal conductivity range depending on percentage of Cu content.

The Cu-Mo alloys (material 3-2) exhibit outstanding CTE and thermal conductivity. The CTE of Cu-Mo alloy can match with other components by adjusting the Mo/Cu ratios. The ratio may therefore be selected to reduce the difference in the CTE between the clip and the semiconductor die material, thereby reducing the internal thermal stresses and helping to maintain the device's operation functionality and reliability. Cu-Mo also provides good machinability. Because of copper's incorporation, the hardness is reduced and plasticity increased relative to pure molybdenum, which is beneficial to machining (e.g. for processing into complex shape components). It also provides an alternative to W-Cu for weight sensitive applications.

A Cu-Mo-Cu (CMC) laminate (material 3-2-3) is a three-layered structure that consists of two outer copper layers and one molybdenum core layer. CMC has a better thermal conductive (CT) and CTE than Mo. It has better machinability than both pure Mo and Mo-Cu composites, therefore providing easier manufacturability for various shapes of electrical interconnection clips. While not shown in Figure 8, it will be understood that a corresponding laminate structure comprising Cu-W-Cu (i.e. a material 3-1-3 combination) may also be provided, as may other laminate structures comprising various combinations of the materials 1, 2, 3, 3-1 and 3-2.

A comprehensive multi-physics based design approach considering the structure, material and application scenario has been applied within the context of clip design for power cycling life time. Preliminary clip design concepts were modelled in 3D modelling software and exported to ANSYS multi-physics simulation software for design evaluation. By utilising an iterative design process together with FEA results, the optimisation to the clip characteristics identified based on clip thickness, stress relief design and clip materials. A clip thinner than 0.5mm was likely to experience excess joule heating under electrical load and a clip above 1.5mm thickness was deemed excessive for the intended purpose. The optimised thinner design may provide a low CTE mismatch with a semiconductor die, while the provision of through-holes or blind-holes in the clip may assist in further reducing induced stress at the component joining locations. In some embodiments, a clip of at least 100µm total thickness, for example 200µm to 500µm, may provide a high confidence that the clip will have the necessary current carrying capability which is preferable for clip interconnections across its intended lifetime. It will be understood that the total thickness of the clip may refer to the combined thickness of all materials forming the clip. For example, the total thickness of a laminate structure clip may comprise the thickness of each layer of the clip, and/or any joining layers.

The skilled person will understand that in the preceding description and appended claims, positional terms such as 'top', 'bottom', 'vertical', etc. are made with reference to conceptual illustrations of an apparatus, such as those showing standard cross-sectional perspectives and those shown in the appended drawings. These terms are used for ease of reference but are not intended to be of limiting nature. These terms are therefore to be understood as referring to a device when in an orientation as shown in the accompanying drawings.

Although the disclosure has been described in terms of preferred embodiments as set forth above, it should be understood that these embodiments are illustrative only and that the claims are not limited to those embodiments. Those skilled in the art will be able to make modifications and alternatives in view of the disclosure, which are contemplated as falling within the scope of the appended claims. Each feature disclosed or illustrated in the present specification may be incorporated in the disclosure, whether alone or in any appropriate combination with any other feature disclosed or illustrated herein.

## Claims

1. A clip for a semiconductor package, the clip comprising:
a first metal and a second metal, wherein the first metal is copper and the second metal is tungsten or molybdenum; and
one or more cavities provided on a first side of the clip, wherein the first side of the clip is configured for attachment to a die top of the semiconductor package.

2. A clip according to claim 1, wherein the clip comprises an alloy of the first and second metals.

3. A clip according to claim 2, wherein the second metal is tungsten, optionally wherein the alloy comprises 75 to 90% tungsten by weight, and further optionally wherein at least one of:
the alloy comprises 90% tungsten and 10% copper.
the alloy comprises 80% tungsten and 20% copper.
the alloy comprises 75% tungsten and 25% copper.

4. A clip according to claim 2, wherein the second metal is molybdenum, and optionally wherein the alloy comprises 65 to 85% molybdenum by weight, and further optionally wherein at least one of:
the alloy comprises 85% molybdenum and 15% copper.
the alloy comprises 70% molybdenum and 30% copper.
the alloy comprises 65% molybdenum and 35% copper.

5. A clip according to claim 1, wherein the clip comprises:
a first layer and a second layer comprising the first metal; and
a third layer positioned between and separating the first and second layers, wherein the third layer comprises the second metal; and
optionally wherein the second metal is molybdenum.

6. A clip according to claim 5, wherein the one or more of the cavities extends from the first side of the clip and only through the first layer.

7. A clip according to claim 6, wherein the clip comprises one or more second cavities provided on a second side of the clip and extending only through the second layer, wherein the second side of the clip is opposite the first side of the clip.

8. A clip according to claim 7, wherein each of the second cavities are aligned with a first cavity.

9. A clip according to any one of claims 5 to 8, wherein the first, third and second layers have a thickness ratio of 13:74:13.

10. A clip according to any one of claims 5 to 8, wherein the first, third and second layers have a thickness ratio of 20:60:20.

11. A clip according to any preceding claim, wherein at least one of the one or more cavities extends from the first side of the clip to a second, opposite side of the clip to thereby form a through-hole.

12. A clip according to any preceding claim, wherein the perimeter of the clip comprises one or more rounded corners.

13. A clip according to any preceding claim, wherein a total thickness of the clip is at least 100µm,

14. A clip according to claim 13, wherein a total thickness of the clip is between 200µm and 500µm inclusive.

15. A semiconductor device or package comprising a clip according to any one of claims 1-14.
